# EUROPÄISCHE PATENTSCHRIFT

(11) **EP 1 011 884 B1**
(45) Veröffentlichungstag und Bekanntmachung des Hinweises auf die Patenterteilung: **20.11.2002**
(21) Anmeldenummer: 98945322.0
(22) Anmeldetag: 10.09.1998
(51) Int. Cl.: B21C 25/02, B21C 25/10

(54) **STRANGPRESSWERKZEUG SOWIE VERFAHREN ZU DESSEN HERSTELLUNG**
EXTRUSION DIE AND ITS PRODUCTION
OUTIL DE PRESSE A FILER ET SON PROCEDE DE FABRICATION

(30) Priorität: 10.09.1997 DE 19739631; 12.02.1998 DE 19805746; 09.03.1998 DE 19810015
(43) Veröffentlichungstag der Anmeldung: 28.06.2000
(73) Patentinhaber: WEFA Singen GmbH, 78224 Singen (DE)
(72) Erfinder: MAIER, Bruno, D-78237 Rielasingen-Worblingen (DE)
(74) Vertreter: Hiebsch, Gerhard F., Dipl.-Ing.
(86) Internationale Anmeldenummer: EP9805762
(87) Internationale Veröffentlichungsnummer: WO99012671

(56) Entgegenhaltungen:
- DE-A- 2 943 585
- GB-A- 1 542 856
- PATENT ABSTRACTS OF JAPAN vol. 009, no. 034 (M-357), 14. Februar 1985 & JP 59 178122 A (SUMITOMO DENKI KOGYO KK), 9. Oktober 1984
- PATENT ABSTRACTS OF JAPAN vol. 008, no. 150 (C-233), 12. Juli 1984 & JP 59 053673 A (SHIN NIPPON SEITETSU KK;OTHERS: 01), 28. März 1984
- PATENT ABSTRACTS OF JAPAN vol. 009, no. 057 (M-363), 13. März 1985 & JP 59 193713 A (HITACHI KINZOKU KK;OTHERS: 01), 2. November 1984
- PATENT ABSTRACTS OF JAPAN vol. 096, no. 007, 31. Juli 1996 & JP 08 066720 A (NIPPON LIGHT METAL CO LTD), 12. März 1996

## Beschreibung

Die vorliegende Erfindung betrifft ein Strangpresswerkzeug -- insbesondere eine scheibenartige Pressmatrize mit zumindest einem Formgebungsdurchbruch zum Strangpressen von Metall wie Aluminium oder einer Aluminiumlegierung -- aus einem Stahlwerkstoff mit einer Oberflächenbeschichtung nach dem Oberbegriff des Patentanspruches 1. Zudem erfaßt die Erfindung ein Verfahren zum Herstellen eines derartigen Strangpresswerkzeuges sowie dessen Verwendung.

Die Härte -- beispielsweise zum Herstellen von Aluminiumprofilen verwendeter -- herkömmlicher Presswerkzeuge ist für den industriellen Einsatz oftmals nicht ausreichend, um eine befriedigende Verschleißfestigkeit und damit wirtschaftlich sinnvolle Standzeiten zu erreichen. Aus diesem Grund werden solche Strangpresswerkzeuge mit bekannten Härtungsverfahren gehärtet.

Aus Warmarbeitsstählen hergestellte Strangpresswerkzeuge werden gängigerweise nach der spanenden Fertigung auf etwa 46 bis 50 HRC gehärtet und dann durch Schleifen, Senk- und Drahterodieren fertiggestellt; üblicherweise erfolgt dann eine Erprobung des Werkzeuges im Aluminiumpresswerk und -falls notwendig -- eine Korrektur. Ist dann ein Strangpresswerkzeug pressfertig, wird es in der vorbeschriebenen Weise durch Nitrieren auf eine Oberflächenhärte von etwa 1000 HV gebracht; die Praxis hat gezeigt, dass dieser Härtewert im praktischen Einsatz einen hinreichenden Verschleißschutz bietet.

Zu den bekannten Nitrierverfahren gehört das Salzbad-Nitrieren mit Hilfe von Zyanidsalzen. Dieses Verfahren bringt jedoch beträchtliche Umweltprobleme, so dass dessen industrielle Zukunft fraglich ist. Das Nitrieren mittels Gas besitzt den Nachteil, dass die entstehende Härtungs schicht relativ dick ist und dadurch nur eine begrenzte Zähigkeit besitzt. Schließlich gibt es die Möglichkeit des Plasma-Nitrierens, wobei dieses Verfahren sich jedoch insbesondere für Werkzeuge mit dünnen Schlitzen als Durchbrüchen nicht eignet.

Den bekannten Härtungsverfahren durch Nitrieren ist zudem der Nachteil gemeinsam, dass mit zunehmender Temperatur die Härtungsschicht abdiffundiert; bei einer Temperatur von etwa 500° C ist beispielsweise eine durch Salzbad-Nitrieren erreichte Schicht nach etwa fünfzehn Stunden nicht mehr vorhanden.

Ist dann im Pressbetrieb die Nitrierschicht durch Diffusion verschwunden, muß der Pressvorgang unterbrochen werden; das Werkzeug wird freigebeizt, gereinigt und neu nitriert. Bei häufigem Nachnitrieren nahe der Anlaßtemperatur des verwendeten Stahles sinkt außerdem dessen Härte und Grundfestigkeit kontinuierlich ab, was zu vorzeitigem Ausfall führt. So liegt etwa bei dünnwandigen Werkzeugen die erreichbare Standzeit nur zwischen etwa 30 und 100 Pressungen, bevor ein erneutes -- kostenträchtiges -- Nachnitrieren notwendig wird.

Die JP 08066720 befasst sich mit der Herstellung eines Strangpresswerkzeuges insbesondere für Aluminium und weist einen Stahlwerkstoff mit einer aufgedampften Oberflächenbeschichtung auf. Diese Oberflächenbeschichtung besteht aus Bornitrid und wird auf den Stahlwerkstoff mittels eines durch Ionenstrahlen unterstützten Aufdampfprozesses (physical vapour deposition = PVD) unter Zwischenfügen einer zuvor aufgetragenen SiₓN_{y}-Zwischenschicht aufgebracht.

In der JP 59193713 wird ein allgemeines Beschichtungsverfahren für Metalle der Gruppen IVa, Va, VIa des periodischen Systems oder Verbindungen von C, N und B oder einem Keramikwerkstoff erörtert, das sowohl mit dem PVD- als auch mit (chemical vapour deposition) CVD-Verfahren -- aber ebenso mit Schmelzsprühen -- erfolgen kann.

In Kenntnis dieses Standes der Technik hat sich der Erfinder das Ziel gesetzt, ein Strangpresswerkzeug zu schaffen, mit dem nicht nur ein wirksamer und dauerhafter Verschleißschutz -- und mithin eine deutlich verlängerte Standzeit -erreicht wird, sondern auch eine gute Eignung insbesondere für dünnwandige Werkzeuge. Das Herstellungsverfahren soll auf einfache Weise und ohne Belastung der Umwelt durchgeführt werden können.

Zur Lösung dieser Aufgabe führen die Lehren der unabhängigen Patentansprüche; die Unteransprüche geben günstige Weiterbildungen an.

Erfindungsgemäß ist der Grundwerkstoff ein verzugsarmer Warmarbeitsstahl, der, nach dem an vorbestimmten Stellen der Beschichtungswerkstoff, der aus der Titankarbid, Titannitrid, Titanborid Vanadiumkarbid, Chromkarbid, Aluminiumoxid, Siliziumnitrid und Kombinationen von diesen enthaltenden Gruppe ausgewählt ist, durch ein CVD-Gasabscheidungsverfahren -- bevorzugt bei Temperaturen über 1000°C -- auf die Oberfläche des Strangpresswerkzeuges aufgebracht worden ist, anschließend gehärtet worden ist.

Im Rahmen der Erfindung liegt ein Verfahren mit den Schritten
. spanendes Formen des Strangpresswerkzeuges aus einem verzugsarmen Warmarbeitsstahl in die gewünschte Gestaltung;
. Härten und Fertigbearbeiten des Strangpresswerkzeuges;
. Beschichten des geformten Stahlwerkstoffes an vorbestimmten Stellen mit wenigstens einem oben genannten Beschichtungswerkstoff mittels des sog. CVD-Verfahrens;
. erneutes Härten des beschichteten Stahlwerkstoffes.

Das thermisch aktivierte CVD-Verfahren -- Chemical Vapour Deposition -- ist an sich für das Herstellen von Einkristallen, das Imprägnieren von Fasergerüsten mit Kohlenstoff oder Keramiken sowie allgemein für das Abscheiden von dünnen Schichten -- sei es durch Aufwachsen oder durch Diffundieren von Boriden, Karbiden, Nitriden, Oxiden -- bekannt.

Die erfindungsgemäße Vorgehensweise führt zu einer Verschleißschicht für das Strangpresswerkzeug, die ohne weitere Nachbehandlungen die Standzeit des Werkzeugs selbst überdauert. Diese überraschende Eigenschaft entsteht dank der durch das CVD-Verfahren aufgebrachten Beschichtung, die bei Temperaturen von bevorzugt mehr als 1000° C aufgebracht wird; in vorteilhafter Weise setzt dabei die Erfindung oberhalb der herkömmlichen Härtungsverfahren ein, die grundsätzlich unterhalb Temperaturen von etwa 500 bis 600° C -- also der Anlassgrenze des verwendeten Stahlwerkstoffes -- bleiben.

Zwar erfordert das CVD-Beschichten das Härten des fertigen Werkzeuges nach dem Beschichtungsvorgang; jedoch durch genaue Kontrolle der Fließvorgänge in den Werkzeugen und die erfindungsgemäße Auswahl besonders verzugsarmer Warmarbeitsstähle zur Realisierung der Erfindung wird in überraschender und nicht vorhersehbarer Weise diese Technologie beherrschbar und bringt herausragende Härte- sowie Verschleißfestigkeitseigenschaften.

Für die Beschichtung eignen sich im erstgenannten Fall -- wie bereits erwähnt -in vorteilhafter Weiterbildung der Erfindung insbesondere Titankarbid, Titanborid, Vanadiumkarbid, Chromkarbid sowie Aluminiumoxid; je nach Werkstoff lassen sich Mikrohärten zwischen HV = etwa 2 000 und HV = etwa 4 000 erreichen. Besonders Titankarbid oder Aluminiumoxid weisen -- mittels des CVD-Verfahrens aufgebracht -- herausragende Zähigkeitseigenschaften auf, während beispielsweise Chromkarbid in besonderem Maße widerstandsfähig gegen abrasiven Verschleiß und wenig anfällig für Risse oder Poren ist. Insbesondere auch Titankarbid zeichnet sich zudem durch vorteilhafte Reibungseigenschaften aus.

Das erfindungsgemäß eingesetzte CVD-Beschichtungsverfahren, nämlich die direkte Abscheidung der genannten Feststoffe aus der Gasphase, bringt dem vorliegenden Anwendungsgebiet der Strangpressmatrizen zahlreiche Vorteile, die neben Verschleißfestigkeit -- also lange Standzeit -- Härte und Zähigkeit bieten:
- genaue und gleichmäßige Beschichtung, selbst von Werkzeugen mit komplizierter Form; durch das CVD-Prozessen inhärente Streuvermögen ist es insbesondere möglich, mit hoher Genauigkeit eine gleichmäßige Beschichtung aufzubringen;
- günstiges Verhältnis von Fehlerquoten und Werkzeugqualität; durch das gut beherrschbare CVD-Verfahren besteht beim erfindungsgemäßen Herstellen und Beschichten der Strangpressmatrize beträchtliche Prozesssicherheit und gute Reproduzierbarkeit, so dass mit geringstem Ausschuß qualitativ äußerst hochwertige Werkzeuge herstellbar sind;
- hohe Schichthaftung; dank des metallurgischen Charakters der Verbindung wird durch das CVD-Verfahren eine sehr gute Verbindung zwischen Grundwerkstoff und Beschichtung erreicht.

Als Ausgangswerkstoffe zum Herstellen der erfindungsgemäßen Strangpressmatrizen werden zähe, verzugsarme, hochwarmfeste Stähle verwendet, die etwa mit Cr,Mo oder mit Wolfram legiert sind, und die beispielsweise durch ESU (Elektroschlacke-Umschmelzen) für hohe Zähigkeit erschmolzen sind.

Die vorerwähnten Beschichtungsmaterialien, beliebige Kombinationen von diesen, auch mehrschichtig, oder aber alternative, geeignete Werkstoffe, werden dann mittels eines CVD-Prozesses bei Temperaturen zwischen etwa 700 und etwa 1050° C für eine Dauer zwischen 5 und 6 Stunden abgeschieden.

Das so erzeugte Werkzeug wird nach diesem Beschichtungsvorgang erneut gehärtet.

Die verwendete Stahllegierung ist so gewählt, dass durch den mit dem CVD-Beschichtungsprozess verbundenen Temperaturanstieg kein wesentlicher Verzug auftritt. Ein allfälliger Verzug kann bereits bei der Konstruktion des Werkzeuges aufgrund des erwarteten Fließverhaltens des Werkstoffes einbezogen werden.

Entsprechendes gilt für das konkrete Strangpressen -- etwa von Aluminiumprofilen -- mit Hilfe eines derartigen, erfindungsgemäß hergestellten Werkzeuges. Auch das Fiießverhalten des Aluminiums kann berücksichtigt werden und als solches in Gestaltung und Härtung der Strangpressmatrize eingehen. Dabei ist es besonders bevorzugt, eine Berücksichtigung dieses Fließverhaltens im Wege einer voraufgehenden Simulationsrechnung vorzunehmen.

Im Ergebnis wird dann nicht nur eine beträchtlich erhöhte Standzeit erreicht; auch eine Wartung der Werkzeuge, wie eingangs beschrieben, ist praktisch nicht mehr notwendig. Darüber hinaus wird vorteilhaft durch die mittels des erfindungsgemäßen CVD-Verfahrens aufgebrachten Beschichtungswerkstoffe eine geringere Reibung erreicht, wodurch die Verarbeitungs- bzw. Pressgeschwindigkeit der Strangpressmatrize erhöht und eine bessere Profilqualität möglich wird.

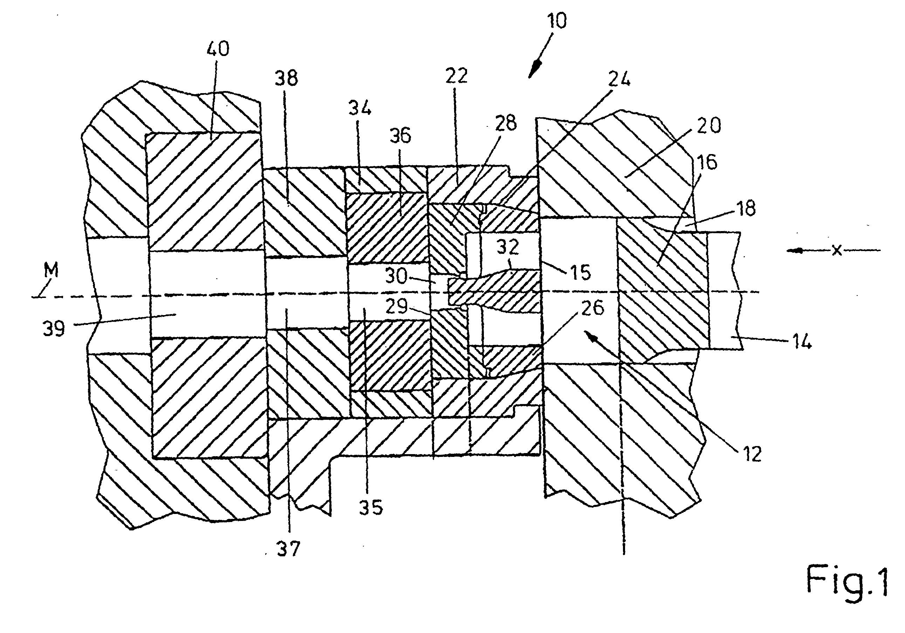

Weitere Vorteile, Merkmale und Einzelheiten der Erfindung ergeben sich aus der nachfolgenden Beschreibung eines bevorzugten Ausführungsbeispiels sowie anhand der Zeichnung; deren einzige Figur zeigt einen schematischen Längsschnitt durch eine Vorrichtung 10 zum Strangpressen von Profilen.

Eine Anlage zum Verarbeiten eines Pressbolzens 12 aus Leichtmetall -- insbesondere aus einer Aluminiumlegierung - - weist an einer ansonsten nicht dargestellten Presse einen Pressstempel 14 mit Pressscheibe 16 auf, der in Pressrichtung x in den Presskanal 18 eines Rezipienten oder Aufnehmers 20 eingeschoben ist.

An der stempelfernen Mündung 15 des Presskanals 14 findet sich in einem Werkzeughalter 22 ein Kammerwerkzeug 24 mit Werkzeugkragen 26 sowie einer in Pressrichtung x anschließenden -- etwa scheibenartigen -- Matrize 28. Letzte enthält einen zentrischen Formdurchbruch 30, der in Längsachse M der Vorrichtung 10 angeordnet ist und das freie Formende eines Dornes 32 aufnimmt.

An die freie Matrizenstirn 29 schließt in Pressrichtung x ein von einem Umfangsring 34 umgebener Zwischenring 36 an, zwischen dem und einem Querhaupt 40 eine Druckplatte 38 vorgesehen ist. Das in jenem Formdurchbruch 30 entstandene -- in der Zeichnung vernachlässigte -- Strangpressprofil wird durch zentrische Durchbrüche 35,37,39 in dem Zwischenring 36 der Druckplatte 38 und dem Querhaupt 40 abgezogen.

Das Werkzeug 24,28,32 ist aus einem verzugsarmen Warmarbeitsstahl geformt sowie mit einer -- nach dessen spanabhebender Bearbeitung -- mit einer in der Zeichnung nicht erkennbaren Verschleißschicht versehen; dies erfolgt durch das an sich bekannte (Chemical Vapour Deposition) CVD-Verfahren bei über 1000°C. Das Werkzeug 24,28,32 wird zum Beschichten auf etwa 1000°C erwärmt und dann mit Titan-, Vanadium- oder Chromcarbid, mit Aluminiumoxid, Titan- oder Siliziumnitrid beschichtet.

Als CVD-Reaktionen werden chemische Reaktionen bezeichnet, bei denen die Ausgangsprodukte als Gase oder Dämpfe vorliegen, das Hauptprodukt als Festkörper ausgeschieden wird und die Nebenprodukte gasförmig sind. Beispielhaft sei hier die Bruttoreaktionsgleichung für Titannitrid nach dem Hochtemperatur-CVD-Verfahren dargestellt, worin
(g) = gasförmig sowie (s) = fest:

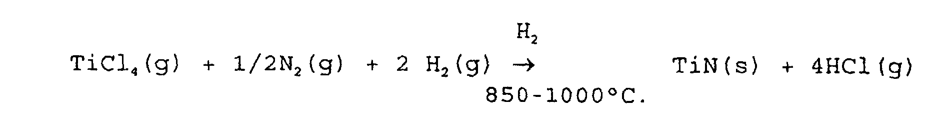

Dabei wird das reduzierende Trägergas (H₂) im Überschuß zugegeben.

Anschließend erfolgt ein Härten des Grundwerkstoffes, nämlich das Abschrecken des Werkzeugstahles und dessen Anlassen, um hohe Härte zu erzielen.

## Patentansprüche

1. Strangpresswerkzeug, insbesondere scheibenartige Pressmatrize, mit zumindest einem Formgebungsdurchbruch zum Strangpressen von Metall wie Aluminium oder einer Aluminiumlegierung, aus einem Stahlwerkstoff mit einer Oberflächenbeschichtung, deren Beschichtungswerkstoff aus der Karbide, Nitride, Boride, Oxide und Kombinationen von diesen Stoffen enthaltenden Gruppe ausgewählt ist, wobei der Beschichtungswerkstoff durch ein CVD-Abscheideverfahren auf das Strangpresswerkzeug aufgebracht ist,
**dadurch gekennzeichnet,**
**dass** der Grundwerkstoff des Strangpresswerkzeuges (24, 28, 32) ein verzugsarmer Warmarbeitsstahl ist, und dass der Stahlwerkstoff anschließend an das Beschichten gehärtet ist, wobei die Mikrohärte zwischen HV = etwa 2000 und HV = etwa 4000 liegt.

2. Strangpresswerkzeug nach Anspruch 1, **dadurch gekennzeichnet, dass** der Beschichtungswerkstoff aus der Titankarbid, Titannitrid oder Titanborid und Kombinationen davon enthaltenden Gruppe ausgewählt ist.

3. Strangpresswerkzeug nach Anspruch 1, **dadurch gekennzeichnet, dass** der Beschichtungswerkstoff aus der Vanadiumkarbid, Chromkarbid, Aluminiumoxid, Siliziumnitrid und Kombinationen davon enthaltenden Gruppe ausgewählt ist.

4. Strangpresswerkzeug nach Anspruch 3, **gekennzeichnet durch** einen Beschichtungswerkstoff aus oder mit Titan-, Vanadium- und/oder Chromkarbid.

5. Strangpresswerkzeug nach Anspruch 3, **gekennzeichnet durch** einen Beschichtungswerkstoff aus oder mit Titan- und/oder Siliziumnitrid.

6. Strangpresswerkzeug nach Anspruch 3, **gekennzeichnet durch** Aluminiumoxid als Beschichtungswerkstoff.

7. Strangpresswerkzeug nach Anspruch 3, **gekennzeichnet durch** Titanborid als Beschichtungswerkstoff.

8. Strangpresswerkzeug nach einem der Ansprüche 1 bis 7, **dadurch gekennzeichnet, dass** die mittels eines CVD-Verfahrens hartstoffbeschichtete Strangpressmatrize zum Herstellen zumindest eines Profils aus Aluminium oder einer Aluminiumlegierung ausgebildet ist.

9. Verfahren zum Herstellen eines Strangpresswerkzeugs zum Strangpressen von Metall wie Aluminium oder einer Aluminiumlegierung, insbesondere eines Strangpresswerkzeuges nach einem der Patentansprüche 1 bis 8, mit den Schritten:
- spanendes Formen des Strangpresswerkzeuges aus einem verzugsarmen Warmarbeitsstahl;
- Härten und Fertigbearbeiten des Strangpresswerkzeuges;
- Beschichten des geformten Stahlwerkstoffes an vorbestimmten Stellen mit wenigstens einem karbidischen, nitridischen, boridischen und/oder oxidischen Beschichtungswerkstoff mittels eines CVD-Verfahrens;
- erneutes Härten des beschichteten Stahiwerkstoffes.

10. Verfahren nach Anspruch 9, **dadurch gekennzeichnet, dass** das Härten mittels eines CVD-Verfahrens durchgeführt wird.

11. Verfahren nach Anspruch 9 oder 10, **dadurch gekennzeichnet, dass** das CVD-Verfahren bei einer Temperatur zwischen 700°C und 1100°C, bevorzugt über 1000°C, durchgeführt wird.

12. Verfahren nach Anspruch 9 oder 10, **gekennzeichnet durch** einen Beschichtungswerkstoff aus oder mit Titan-, Vanadium- und/oder Chromkarbid.

13. Verfahren nach Anspruch 9 oder 10, **gekennzeichnet durch** einen Beschichtungswerkstoff aus oder mit Titan- und/oder Siliziumnitrid.

14. Verfahren nach Anspruch 9 oder 10, **gekennzeichnet durch** Aluminiumoxid als Beschichtungswerkstoff.

15. Verfahren nach Anspruch 9 oder 10, **gekennzeichnet durch** Titanborid als Beschichtungswerkstoff.

## Claims

1. Extrusion die, in particular a disk-type female press die, having at least one shaping opening for extruding metal such as aluminium or an aluminium alloy, composed of a steel material having a surface layer whose coating material is selected from the group comprising carbides, nitrides, borides, oxides and combinations of these substances, wherein the coating material is applied to the extrusion die by a CVD gravity settling process; **characterised in that** the base material of the extrusion die (24, 28, 32) is a low-warpage hot-worked steel and that the steel material is hardened subsequent to coating, wherein the microhardness is between DPH = approximately 2,000 and DPH = approximately 4,000.

2. Extrusion die according to Claim 1, **characterised in that** the coating material is selected from the group comprising titanium carbide, titanium nitride or titanium boride and combinations thereof.

3. Extrusion die according to Claim 1, **characterised in that** the coating material is selected from the group comprising vanadium carbide, chromium carbide, aluminium oxide, silicon nitride and combinations thereof.

4. Extrusion die according to Claim 3, **characterised by** a coating material composed of or containing titanium, vanadium and/or chromium carbide.

5. Extrusion die according co Claim 3, **characterised by** a coating material composed of or containing titanium and/or silicon nitride.

6. Extrusion die according to Claim 3, **characterised by** aluminium oxide as coating material.

7. Extrusion die according to Claim 3, **characterised by** titanium boride as coating material.

8. Extrusion die according to one of Claims 1 to 7, **characterised in that** the female extrusion die coated with hard material by means of a CVD process is constructed for producing at least one profile composed of aluminium or an aluminium alloy.

9. Method for producing an extrusion die for extruding metal such as aluminium or an aluminium alloy, in particular an extrusion die according to one of Claims 1 to 8, having the steps:
- machine cutting of the extrusion die from a low-warpage hot-worked steel;
- hardening and finishing of the extrusion die;
- coating of the shaped steel material at predetermined points with at least one carbide, nitride, boride and/or oxide coating material by means of a CVD process;
- renewed hardening of the coated steel material.

10. Method according to Claim 9, **characterised in that** the hardening is carried out by means of a CVD process.

11. Method according to Claim 9 or 10, **characterised in that** the CVD process is carried out at a temperature of between 100 °C and 1100 °C, preferably of over 1000 °C.

12. Method according to Claim 9 or 10, **characterised by** a coating material composed of or containing titanium, vanadium and/or chromium carbide.

13. Method according to Claim 9 or 10, **characterised by** a coating material composed of or containing titanium and/or silicon nitride.

14. Method according to Claim 9 or 10, **characterised by** aluminium oxide as coating material.

15. Method according to Claim 9 or 10, **characterised by** titanium boride as coating material.

## Revendications

1. Outil d'extrusion, en particulier matrice de pressage du genre d'un disque, comportant au moins une fente de passage de forme pour l'extrusion d'un métal tel que de l'aluminium ou un alliage d'aluminium, en partant d'un matériau en acier avec un revêtement de surface, dont le matériau de revêtement est choisi dans le groupe comprenant les carbures, les nitrures, les borures, les oxydes et les combinaisons de ces substances, le matériau de revêtement étant appliqué sur l'outil d'extrusion par un procédé de dépôt CVD (procédé chimique de dépôt en phase gazeuse), **caractérisé en ce que** le matériau de base de l'outil d'extrusion (24, 28, 32) est un acier apte à l'usinage à chaud et peu sensible à l'étirage, et **en ce que** le matériau en acier est ensuite trempé sur le revêtement, de sorte que la microdureté soit comprise entre HV = environ 2000 et HV = environ 4000.

2. Outil d'extrusion selon la revendication 1, **caractérisé en ce que** le matériau de revêtement est choisi dans le groupe contenant le carbure de titane, le nitrure de titane ou le borure de titane et leurs combinaisons.

3. Outil d'extrusion selon la revendication 1, **caractérisé en ce que** le matériau de revêtement est choisi dans le groupe contenant le carbure de vanadium, le carbure de chrome, l'oxyde d'aluminium, le nitrure de silicium et leurs combinaisons.

4. Outil d'extrusion selon la revendication 3, **caractérisé par** un matériau de revêtement en ou avec du carbure de titane, du carbure de vanadium et/ou du carbure de chrome.

5. Outil d'extrusion selon la revendication 3, **caractérisé par** un matériau de revêtement en nitrure de titane et/ou de silicium ou avec du nitrure de titane et/ou de silicium.

6. Outil d'extrusion selon la revendication 3, **caractérisé par** de l'oxyde d'aluminium comme matériau de revêtement.

7. Outil d'extrusion selon la revendication 3, **caractérisé par** du borure de titane comme matériau de revêtement.

8. Outil d'extrusion selon l'une des revendications 1 à 7, **caractérisé en ce que** la matrice d'une presse d'extrusion revêtue de matériau dur à l'aide d'un procédé CVD (de dépôt chimique en phase gazeuse) est réalisée pour fabriquer au moins un profil en aluminium ou en alliage d'aluminium.

9. Procédé de fabrication d'un outil de pressage d'extrusion pour l'extrusion d'un métal, tel que de l'aluminium ou un alliage d'aluminium, en particulier un outil d'extrusion selon l'une des revendications 1 à 8, le procédé comprenant les étapes consistant :
- à former par enlèvement de copeaux l'outil d'extrusion à partir d'un acier à l'usinage à chaud apte et peu sensible à l'étirage ;
- à soumettre à la trempe et au parachèvement l'outil d'extrusion ;
- à revêtir le matériau en acier mis en forme, à des emplacements prédéterminés avec au moins un matériau de revêtement en carbure, en nitrure, en borure et/ou en oxyde, à l'aide d'un procédé CVD (dépôt chimique en phase vapeur) ;
- à tremper de nouveau le matériau d'acier revêtu.

10. Procédé selon la revendication 9, **caractérisé en ce que** la trempe est réalisée au moyen d'un procédé CVD (dépôt chimique en phase vapeur).

11. Procédé selon la revendication 9 ou 10, **caractérisé en ce que** le procédé CVD est réalisé à une température comprise entre 900°C et 1100°C, de préférence supérieure à 1000°C.

12. Procédé selon la revendication 9 ou 10, **caractérisé par** un matériau de revêtement en carbure de titane, de vanadium et/ou de chrome ou avec du carbure de titane, de vanadium et/ou de chrome.

13. Procédé selon la revendication 9 ou 10, **caractérisé par** un matériau de revêtement en nitrure de titane et/ou en nitrure de silicium, ou bien avec du nitrure de titane et du nitrure de silicium.

14. Procédé selon la revendication 9 ou 10, **caractérisé par** de l'oxyde d'aluminium comme matériau de revêtement.

15. Procédé selon la revendication 9 ou 10, **caractérisé par** du chlorure de titane comme matériau de revêtement.
